# EUROPEAN PATENT SPECIFICATION

(11) **EP 2 742 589 B1**
(45) Date of publication and mention of the grant of the patent: **10.08.2016**
(21) Application number: 12836740.6
(22) Date of filing: 28.09.2012
(51) Int. Cl.: H02J 1/10

(54) **SYSTEM FOR COMBINING DIRECT CURRENT POWER FROM MULTIPLE INPUTS**
SYSTEM ZUR KOMBINATION EINER GLEICHSTROMLEISTUNG AUS MEHREREN EINGÄNGEN
SYSTÈME PERMETTANT DE COMBINER LA PUISSANCE EN COURANT CONTINU DE PLUSIEURS ENTRÉES

(30) Priority: 30.09.2011 US 201161541206 P
(43) Date of publication of application: 18.06.2014
(73) Proprietor: Solarbos Inc., Livermore, CA 94551 (US)
(72) Inventor: RUSSO, Peter, R., Oakland, CA 94608 (US); SCHRIPSEMA, Jason, Sacramento, CA 94110 (US)
(74) Representative: Appleyard Lees IP LLP
(86) International application number: PCT/US2012/057816
(87) International publication number: WO 2013/049501

(56) References cited:
- JP-A- 2011 101 537
- KR-B1- 100 996 627
- KR-B1- 100 999 978
- US-A1- 2011 090 607
- US-A1- 2011 121 984
- US-B1- 6 215 636

## Description

### Field of the Invention

The present invention relates to the field of combining multiple power sources to provide a single output. More specifically, the present invention relates to a system for combining the power generated by multiple solar panels or multiple solar panel arrays.

### Background

The use of solar panels to produce electricity continues to expand as individuals and business seek ways to reduce electrical costs and greenhouse gas emissions. As the use of solar power increases, so do the size of the arrays used to produce the solar power. In order to harness the energy it is desirable to combine the electrical output from portions of the array, but to be able to monitor the output of the various portions to detect if there is a malfunction in a certain section of a solar array. One malfunction that can result in significant damage is arcing. Large solar arrays produce high voltages, and if there is a short in one of the circuits from the array, the wires will arc as long as the solar panels are in the sunlight. The electrical arc can produce extremely high temperatures that can burn or melt through insulation, connectors, or enclosures and start fires. Document US2011-0121984A1 discloses a system for combining direct current produced by a plurality of photovoltaic elements.

### Summary of the Invention

The present invention provides a system for combining direct current power produced by a plurality of photovoltaic elements according to claim 1 herein. In one aspect, the system includes a sensor for sensing the current from a plurality of photovoltaic sources and a noise detector for detecting the noise in the current from the plurality of photovoltaic sources. A controller connected with the sensor and the noise detector is configured to determine whether a fault is present based on signals from the sensor and the noise detector. If the controller determines a fault as occurred, the controller may control a switch to disconnect the photovoltaic elements from the output circuit.

The system further provides a mechanism for monitoring the current of each electrical input from each source circuit. More specifically, the system includes a combiner assembly attached to a plurality of photovoltaic source circuits that creates an output circuit. The output from one or more source circuits is connected to a busbar. The busbar includes a plurality of elongated fingers each of which is in electrical communication with the output from at least one of the source circuits. A sensor adjacent each finger of the busbar detects the current passing through the finger of the busbar. The sensor provides a signal indicative of the amount of current flowing through the respective finger of the busbar. The system further includes a noise detection assembly for detecting noise in the current of the busbar to indentify noise indicative of a fault in one or more of the source circuits.

According to another aspect, the current sensors may be Hall effect sensors and signals produced by the Hall sensors can be used to measure the amount of current produced by each source circuit as well as to detect problems in a source circuit such as an arc fault.

According to another aspect, the noise detection assembly may include a current transformer for detecting the current flowing from the busbar to an output contact. The current transformer may create a current in response to noise in the current flowing from the busbar. The assembly may also include a contactor to disconnect the output of the combiner assembly in the case a fault is detected thereby interupting the flow of current in the arcing circuit.

### Description of the Drawings

The foregoing summary and the following detailed description of the preferred embodiments of the present invention will be best understood when read in conjunction with the appended drawings, in which:
Fig. 1 is a plan view of a system for combining direct current power;

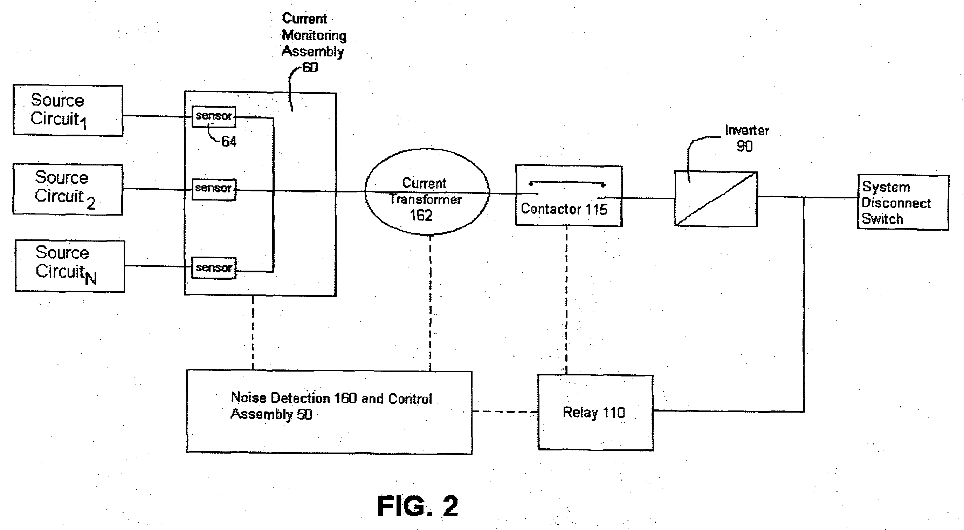

Fig. 2 is a schematic diagram of the system illustrated in Fig. 1;
Fig. 3 is a schematic diagram of the system for combining direct current power illustrated in Fig. 1;
Fig. 4 is a schematic diagram of current monitoring and noise detection assemblies of the system for combining direct current power illustrated in Fig. 1;
Fig. 5 is a fragmentary perspective view of a busbar and current monitoring assembly of the positive input assembly illustrated in Fig. 1;
Fig. 6 is a perspective view of the busbar illustrated in Fig. 5;
Fig. 7 is a schematic of a circuit of a noise detection circuit of the system illustrated in Fig. 1.

### Detailed Description of the Invention

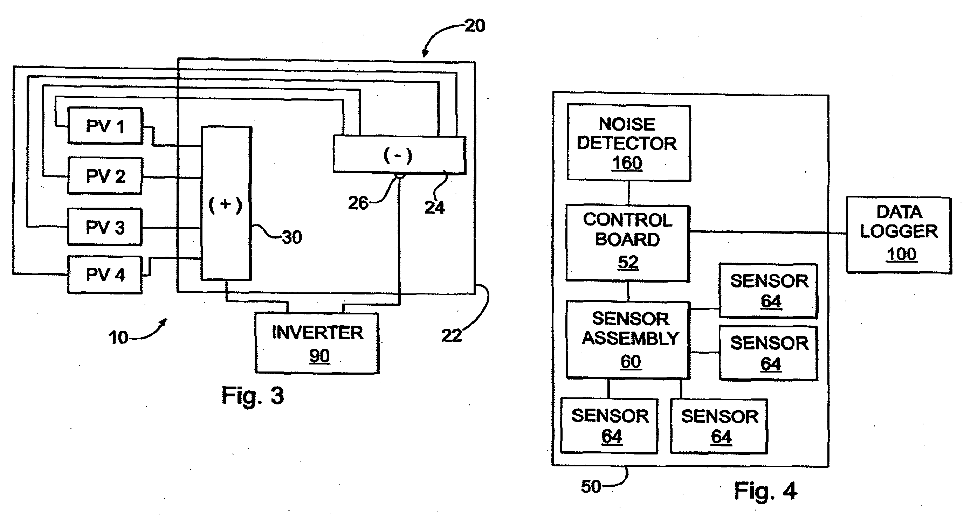

Referring now to the figures, a system for combining direct current power is designated generally 10. The system 10 includes a combiner box 20 for receiving the power output from a plurality of power producing devices, such as solar panels designated PV1, PV2, PV3, PV4 in Fig. 3. The combiner box 20 includes an enclosure, such as a weatherproof steel or fiberglass box 22. Mounted in the box 22 is a negative terminal assembly 24 and a positive terminal assembly 30. The power producing devices PV1-PV4 are connected with the positive and negative terminal assemblies 24, 30 and combined to produce a single DC output.

Referring now to Fig. 3, the details of the system 10 will be described in greater detail. The electrical generating elements may be any of a variety of devices for producing electricity. In the present instance, the electrical generating elements are photovoltaic (PV) cells. More specifically, the electrical generating elements are a plurality of solar panels. Each electrical input to the combiner box 20 may be from a single solar panel. However, in the present instance, the output from a plurality of solar panels is interconnected to provide a single electrical output. These interconnected solar panels are referred to as a string. A plurality of the strings forms an array of solar panels. In Fig. 3 the system includes four strings identified as PV1, PV2, PV3 and PV4. However, it should be understood that PV1-PV4 may represent a single panel or multiple panels. Additionally, although the present system is particularly suited for solar power applications, the system is also operable with non-solar power producing elements. In non-solar applications, PV1-PV4 would represent alternative power producing elements.

In Fig. 3, the output from each string (PV1-PV4)is connected with the negative terminal assembly 24 and the positive terminal assembly 30. The negative terminal assembly 24 comprises a terminal block to provide a common conductor for all of the negative conductors from the strings. The negative terminal assembly 24 includes a plurality of sockets and corresponding connectors for receiving and retaining a conductor from one of the strings. Additionally, the negative terminal assembly 24 includes an output lug 26 for connecting an output negative conductor from the terminal assembly.

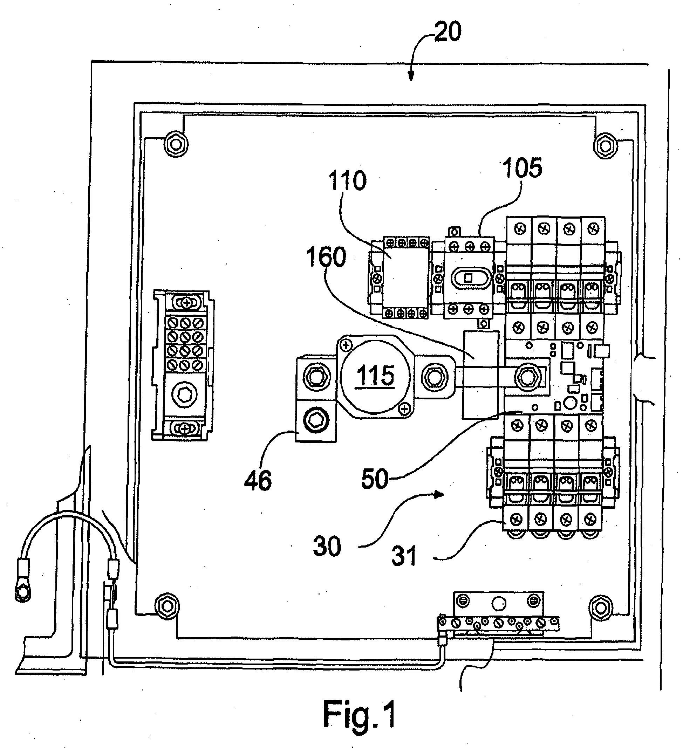

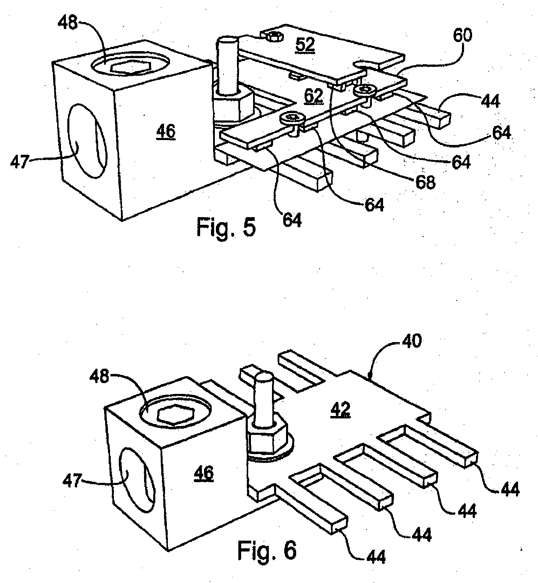

The positive terminal assembly 30 will now be described in greater detail with reference to Figs. 1 & 5-6. The positive terminal assembly 30 includes a bus bar 30 attached to a plurality of over-current protection protection elements, such as circuit breakers or fuses. In the present instance the over-current protection elements are fuses, each of which is housed in a fuse holder 31. Figures 5-6 illustrate an exemplary embodiment in which the positive terminal assembly is configured to receive conductors from up to eight power inputs (e.g. eight solar panel strings PV1-PV8). The assembly may be configured so that all of the positive conductors connect to the assembly on a single side. However, in the present instance, the assembly provides a dual-sided configuration with a pair of parallel rows of fuse holders 31. As discussed further below, the front face of each fuse holder 31 opposes the front face of a fuse holder in the opposite row, so that the front faces of the fuse holders form a channel between the rows, with a busbar 40 connecting the rows of fuse holders.

Each fuse holder 31 includes a wire socket for receiving a positive conductor from one of the power inputs (i.e. PV1-PV8). A connector on each fuse holder is operable to retain the wire in the wire socket. For instance, the connector may be a threaded element operable to clamp the wire to retain the wire in the socket. Similarly, the fuse holder 31 also includes a second socket for connecting the fuse holder to the bus bar socket. A second connector for each fuse holder 31 is operable to retain the busbar in the second socket. In the present instance, the second connector is similar to the wire connector 34, so that threading the connector clamps the busbar in the second socket. An exemplary fuse holder 31 for the positive terminal assembly 30 is a fuse holder made by Wohner under the name AMBUS EasySwitch part number 31110.

An exemplary busbar 40 of the positive terminal assembly 30 is illustrated in Fig. 6. The busbar 40 Is an electrically conductive element, such as copper, aluminum or other highly conductive material. The busbar 40 includes a central conductive body 42 and a plurality of elongated fingers 44 that project away from the central body portion. In the present instance, the fingers are spaced around the central body to form two rows of fingers, however, the busbar may be configured so that the fingers extend from a single side of the central body or alternatively from one or both of the ends.

In the present instance, each row of fingers comprises a plurality of generally parallel fingers spaced apart from one another along an edge of the central body 42. The fingers 44 are elongated so that each finger has two portions. The first portion is a terminal end portion that extends into a bus connector 33 of one of the fuse holders. The second portion is an intermediate portion that extends between the front face 37 of the fuse holder and the edge of the bus bar. In the present instance, the intermediate portion of the finger is at least approximately ¼ of the length of the finger and maybe at least approximately 1/3 the length of the finger. In this way, the elongated fingers may extend into the fuse holder to form an electrical connection with the fuse holder, while maintaining the central body of the busbar spaced apart from the fuse holder.

As described above, each finger 44 of the busbar may be configured to be connected with a fuse holder, so that each busbar finger is in electrical communication with a positive conductor of one of the strings of solar panels. In this way, the central body of the bus bar is in electrical communication with all of the strings connected with the positive terminal assembly, thereby combining all of the power produced by the strings attached to the assembly.

An output lug 46 electrically connected to the busbar provides a unitary output connection from the busbar. The output lug 46 includes a socket 47 for receiving a conductor and a connector 48, such as a set screw or other threaded element for retaining an output conductor in the socket of the output lug. In this way, an output conductor can provide an output for the combined current of the power connected to the positive terminal assembly from the strings of solar panels. The positive output conductor and the negative output conductor can be connected with a downstream element in the circuit. For instance, the output from the combiner 20 may be connected with an inverter 90 as shown in Fig. 3. The inverter 90 inverts the power from direct current to alternating current. Although the output from the combiner box 20 may be connected with an inverter, the system is not limited to a circuit in which the output is fed to an inverter. For instance, the output may be connected to another PV combiner or a power storage device, such as a battery or an array of batteries.

In the present instance, the system also includes a current monitoring assembly 60 for monitoring the current flowing to the positive terminal assembly and a noise detection assembly 160 for detecting noise indicative of an arc in one of the source circuits. The current monitoring assembly 60 is operable to detect whether there is a reduction in the current supplied by one or more of the strings connected with the circuit. The noise detection assembly 160 is operable to detect noise indicative of an arc.

In the present instance, the control assembly 50 comprises a microprocessor for receiving signals from the noise detection assembly 160 and signals from the current monitoring assembly 60. The control assembly determines whether the signals from the noise detection assembly and the current monitoring assembly indicate a malfunction in one of the source circuits. If the control assembly determines that a malfunction exists, the controller may automatically disconnect the output from the combiner box as discussed further below.

Additionally, the control assembly 50 may include a data communication element and an output connector so that signals from the control assembly may be exported to a data logging element 100. For instance, the control assembly may include a communication element for providing a signal using a common protocol, such as ModBus for communicating the sensor data and/or the noise detection data to a remote device, such as a ModBus capable data logger, inverter or power meter. The remote device may log and/or analyze the data from the control board to determine whether the data indicates an error or malfunction in one or more of the power input elements (i.e. PV1-PV4), as well as identifying which of the input elements should be analyzed to determine if there is a malfunction. The remote device may then provide signals or warnings to the operator indicating the detected malfunction and which power input element(s) appear to have a malfunction or other performance issue.

The current monitoring assembly 60 may include a plurality of sensors 64, each of which detects a characteristic of the electrical flow from one of the strings of solar panels. The sensors may be any of a variety of current detecting sensors, however, in the present instance, the current detecting sensors are Hall effect sensors 64.

The Hall effect sensors 64 may be mounted on a circuit board 62 that is positioned adjacent the busbar 40. The sensors 64 may be spaced apart along the circuit board so that each sensor is positioned adjacent one of the fingers 44 of the busbar. In particular, in the present instance, the sensors 64 are spaced apart to form two rows of sensors spaced apart from one another a distance substantially similar to the distance between adjacent fingers 44 of the busbar. In this way, each sensor is proximate one of the fingers to detect variations in the current in the respective finger. Additionally, each sensor is positioned closer to the respective busbar finger 44 that it is monitoring than to any of the remaining busbar fingers or than to the central body 42 of the busbar.

The sensors may be mounted on a circuit board that includes control elements or signal processing elements that process the signals from the sensors 64. However, in the present instance, the control assembly 50 is electrically connected with the sensors 64 on the sensor board 62, so that the control assembly receives and analyzes the signals from the sensors 64.

The control assembly 50 may process the signals from the sensors 64 to detect whether the signal indicates a fluctuation in the input current (or voltage) that would be indicative of a problem with an element in the string connected with the respective busbar finger. In other words, if PV1 is connected to a first busbar finger, and the sensor 64 associated with the first finger detects a current below a predetermined threshold, then the control board may process the signal from the first sensor and provide a signal indicative of a malfunction in the first string of solar panels. However, as discussed further below, the decision that a malfunction is present is also based upon the detection of noise in the line.

Referring to Fig. 1, the sensor assembly 60 and the control assembly 50 are disposed above the central body 42 of the busbar in the channel formed between the two rows of fuse holders 31. A thin electrically insulative layer 66 may be disposed between the busbar 40 and the sensor assembly 60. The insulative layer insulates the sensors 64 from the current in the central body 42 of the busbar or from the current flowing through adjacent fingers 44 of the busbar. The insulative layer may be formed of a variety of materials, and in the present instance is a thin sheet of mica. A thin sheet of polyester could also be used.

The positive terminal assembly 30 may also incorporate a power supply designed to utilize power from the high voltage DC busbar to operate the current monitoring system 60. Specifically, the busbar may operate under normal conditions at a voltage of 300-600 volts DC with respect to the ground plane. The power supply provides an operating voltage for the current monitoring system that is 5, 12 or 24 volts below the busbar voltage. Accordingly, the power supply allows the circuit board to operate at a voltage that is no more than approximately 24 volts different from the busbar voltage.

In some applications or configurations, it may be desirable to account for noise and/or background effects that could affect the signal produced by the hall effect sensors 64, such as magnetic fields produced by adjacent elements on the bus bar 40. Specifically, as discussed above, the bus bar 40 may include a plurality of separate elements, such as fingers 44, each of which may be connected with a separate input circuit. A separate Hall effect sensor may be mounted on each elongated finger to monitor the current flowing from the respective input circuit to the bus bar 40. The magnetic fields produced by current flowing through one of the fingers may produce a magnetic field that is sensed by more than one of the sensors in the sensor assembly. For instance, the sensor for detecting the current flowing through the first finger of the bus may also detect the magnetic field produced by current flowing through the second and third fingers. In fact, in some configurations, each sensor may detect some magnetic field produced by the current flowing through each of the other fingers.

In order to assess the current flowing through each finger, it may be desirable to compensate the signal from each sensor to account for the signal received from adjacent fingers or other signal that is not indicative of the current flowing through the particular finger. One manner of processing the signal to account for field produced by adjacent fingers is to determine a baseline sensor value for each sensor as follows. For a bus of N fingers, a known current is applied to the first finger and no current is applied to each of the remaining fingers. The sensors on fingers 2 through N are evaluated to determine what magnetic field is sensed in response to the current flowing through finger 1. The know current is then applied to finger 2 and no current is applied to fingers 1 and 3 through N. The sensors in fingers 1 and 3-N are evaluated to determine what magnetic field is sensed in response to the current flowing through finger 2. Similarly, the current is applied separately to each finger and the sensors are evaluated for each finger to determine what magnetic field is sensed at each finger in response to the signal flowing to each particular finger.

After applying the known current to each of the fingers and measuring the resulting magnetic field sensed by the sensors, the background noise a sensor senses can be determined, which can be compensated for when processing the signal for the sensor. Specifically, the compensation signal for background noise produced by current flowing through a finger (other than the current flowing through the finger being monitored) is proportional to the signal detected when current was applied to the finger while no current was applied to the remaining fingers. The baseline value for a sensor is based upon a summation of the compensation for each finger on the bus (other than the finger being monitored).

By way of example, for a bus having four fingers F1, F2, F3, F4, the compensation C1,2 for the sensor on F1 that compensates for the magnetic field produced by current flowing through F2 is proportionate to the signal detected by the sensor on F1 when the known current is applied to F2 and no current is applied to F1 and F3-F4. Similarly, the compensation C1,3 for the sensor on F1 that compensates for the magnetic field produced by current flowing through F3 is proportionate to the signal detected by the sensor on F1 when the known current is applied to F3 and no current is applied to F1, F2 and F4. The compensation C1,4 for the sensor on F1 that compensates for the magnetic field produced by current flowing through F4 is proportionate to the signal detected by the sensor on F1 when the known current is applied to F4 and no current is applied to F1-F3. The baseline is the sum of C1,2+ C1,3+ C1,4. In this way, a table of values can be generated for each finger based upon the compensation values for each other finger. The table can be used to determine the baseline for each finger.

As discussed above, a drop in current coming detected by one of the sensors 64 may be indicative of a malfunction in one of the source circuits. However, the drop in current may result from an event other than a malfunction. For instance, a drop in current may result from a sudden shading of a photovoltaic assembly. Accordingly, it may be desirable to incorporate a second characteristic feature indicative of a malfunction in one of the source circuits and base the determination of a malfunction on both the current variation detected by the sensor assembly 60 and the second characteristic.

In the present instance, electrical noise in the line from the source circuits can be monitored and used as a second characteristic for determining the presence of a malfunction in one of the source circuits. When arcing occurs in a source circuit, the arcing typically creates electrical noise. By monitoring the electrical noise in the system, the presence of electrical noise indicative of arcing in a source circuit may be used to detect the presence of a malfunction.

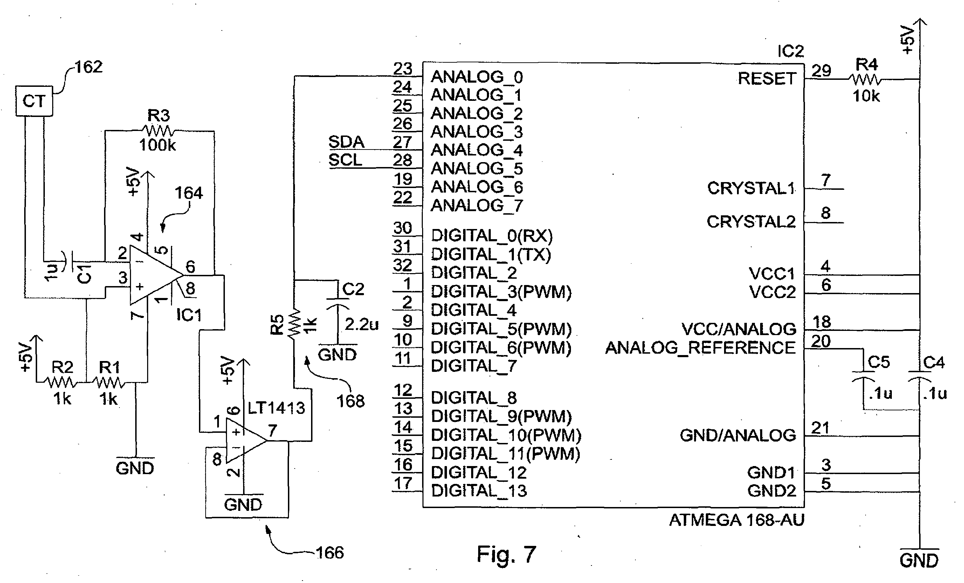

Referring now to Figs 1 and 7, the details of the noise detection assembly 160 will be described in greater detail. A variety of elements can be used to detect noise. The noise can be detected for each line coming from each respective source circuits. However, in the present instance, the noise is detected for the combined current of all of the source circuits. Specifically, the noise detection assembly 160 detects the noise in the current flowing from the busbar 40 to the output lug 46.

In the present instance, the noise detection assembly includes an annular current transformer 162 and a conductor from connected with the busbar passes through the current transformer. Since the current from the busbar is direct current, theoretically, the current transformer 162 will produce little or no current in response to the current flowing from the positive current assembly. In reality, noise from various elements in the system will create an alternating current component that will induce a current from the current transformer 162. The electrical noise created by arcing in the source circuit creates noise, which can induce a current from the current transformer 162. Therefore, by monitoring the output from the current transformer 162 and compensating for the noise produced by other elements during normal operation, the system 10 can identify the presence of noise indicative of a malfunction such as arcing in one of the source circuits.

The noise detection assembly 160 includes elements for processing the current produced by the current transformer in response to noise in the current from the busbar 40. Referring to Fig. 7 a schematic is provided for the noise detection assembly. A high gain op-amp 164 is coupled with the current transformer 162 and converts AC current in the current transformer into a voltage signal at 10 V/mA. A unity gain buffer op-amp 166 buffers the signal from the high-gain op-amp to impede downstream filters from affecting the gain of the high-gain op-amp 164. A low-pass RC filter 168 receives the signal from the second op-amp and removes transients from the signal. From the low-pass filter 168, the signal is communicated to a microcontroller that converts the signal from analog to a digital signal. The microcontroller may be separate from the control assembly 50 and the signal can then be communicated with the control assembly. However, in the present instance, the signal is communicated directly with the control assembly 50, which also receives the signal from the current sensing assembly 60.

The microprocessor of the control assembly evaluates the signal from the noise detection assembly 160 to evaluate whether the signal is indicative of noise created by a malfunction or whether the signal represent noise generated by ambient noise from the normal operation of the system. A variety of methodologies can be utilized to evaluate whether a signal corresponds to ambient noise or noise indicative of a malfunction. For instance, the signal from the noise detection assembly 160 can be compared against a threshold to evaluate whether the noise is indicative of a malfunction. In a threshold methodology, the microprocessor samples the signal and evaluate whether the sample exceeds a threshold. If the sample exceeds the threshold, the sample is indicative of a malfunction, such as arcing. If a predetermined number of samples indicative of a malfunction occur within a predetermined time window the control assembly declares that the noise is indicative of a malfunction. If the signal from the current sensor assembly 60 also indicates a variation of current in one of the source circuits, then the controller 50 determines that there is a malfunction in the source circuit and the output of the system may be automatically disconnected as discussed further below.

As discussed above, the microprocessor may compare the signal from the noise detection assembly against a threshold to evaluate whether the noise is indicative of a malfunction. Alternatively, the microprocessor may sample the signal a predetermined number f times within a first time window and compute an average value for the samples. The microprocessor then samples the signal a predetermined number of times in a second time window and the average absolute deviation for the samples in the second time window relative to the average calculated for the first time window is determined. A running average for the average deviation in both time windows is also calculated. If the average deviation for the samples in the second time window is a predetermined amount larger than the running average, then a noise event is identified. If the current sensing assembly 60 also indicates a drop in current indicative of an arc, then the control assembly indicates a malfunction and may automatically disconnect the output of the system.

As described above, a variety of methods can be used to determine whether the signal from the noise detection assembly 160 is indicative of ambient noise or is indicative of a malfunction, such as arcing, in one of the source circuits. The system may be configured to declare a malfunction based solely on an analysis of the signal from the noise detection. However, in the present system, the controller makes a determination of a malfunction based on the combination of signals from the noise detection assembly 160 and the current sensing assembly 60. If only one of the noise detection assembly and the current sensing assembly provides a signal indicative of a malfunction, then the control assembly 50 does not declare a malfunction. However,, if the noise detection assembly and the current sensing assembly both provide a signal indicative of a malfunction, then the control assembly 50 declares a malfunction and responds accordingly, such as by automatically disconnecting the output from the system.

As discussed above, it may be desirable to automatically disconnect the output from the combiner box 20 in response to a characteristic of the output from one or more of the source circuit(s). Accordingly, a contactor 115 may be placed in the circuit between the positive terminal assembly 30 and the positive output lug. The contactor 115 comprises one or more normally open switches, so that the output from the combiner box 20 is normally switched off. An exemplary contactor is a series GX14 EPIC contactor sold by GIGAVAC a company in Carpinteria, California. A power supply 120 provides power to the contactor that can energize the contactor to close the one or more normally open switches so that current can flow from the combiner box 20 to the grid so that the electricity from the source circuits can be used. If the power to the contactor 115 from the power supply 120 is interrupted, the contactor opens the circuit to prevent the flow of electricity from the source circuit(s). The system 10 may include a switch to interrupt the power from the power supply to the contactor. The interrupt switch may include a manually operable actuator, and the power supply may be remote from the combiner box so that circuit between the combiner and the inverter can be controlled remotely.

Current from the combiner box may be switched off if noise indicative of arcing is detected in the line, and if the current from one or more of the source circuits falls outside an acceptable range. By way of example, if the current from one of the source circuits falls below a threshold then the reduced current may be indicative of a fault in the source circuit. Similarly, variation in the current from a source circuit exceeding a predetermined range within a predetermined time may be indicative of arcing in the source circuit. Additionally, detecting noise in the line that is greater than ambient noise or noise having a particular characteristic may be indicative of arcing in the source circuit. In response to the change in detected current, combined with detection of noise characteristic of arcing, the circuit from the combiner box 20 may be automatically interrupted.

In one embodiment, the circuit from the combiner box 20 may be automatically interrupted by a relay 110 controlling the power from the power supply 120 to a contactor 115. The relay 110 may be controlled automatically by a variety of control circuits. In the present instance, the relay 110 is controlled by the control assembly 50. Specifically, the control assembly 50 may control the relay in response to the current detected by one or more of the sensors in the sensor assembly and the noise detected by the noise detection assembly.. More specifically, the control assembly 50 may be configured so that the relay is switched to an open state in response to the control assembly determining that the signal from the current transformer indicates a malfunction and the signal from the current monitoring assembly indicates a malfunction. For instance, in an application in which the combiner box 20 receives power from a plurality of solar panels, each finger of the bus 40 is connected to different panels or arrays. Therefore, the current sensed by each Hall effect sensor may differ from the current detected by the other Hall effect sensors. However, the current detected by each sensor is generally stable over time under normal operating conditions. In contrast, if there is a problem in one of the source circuits, such as an arcing fault, the current may vary significantly more than under normal operating conditions. Accordingly, the current monitoring assembly may be configured so that in response to detecting a varying current in one of the bus fingers combined with the noise dection system 160 detecting noise indicative of arcing, the control assembly controls the relay to open the circuit, thereby interrupting the power from the combiner box to the grid. More specifically, switching the relay to an open condition opens the circuit from the power supply 120 to the contactor 115, thereby shutting off the flow of electricity from the combiner box to the grid. In one example, if the current varies more than a predetermined amount or percentage in a predetermined time and during that time the current transformer detects noise that is a predetermined amount or percentage above ambient noise, the control assembly sends a signal to the relay 110 to open the circuit.

In the foregoing description, the relay 110 is operable to open or close the circuit from the combiner box to the grid. It should be understood that any of a variety of automatically controllable electro-mechanical switches may be controlled to open the circuit from the combiner 20 to the grid to interrupt the flow of electricity from the source circuits to the grid. Additionally, the relay may be a normally closed relay that receives a signal from the current sensing assembly to open in response to a fault, or the relay may be a normally open relay that receives a signal from the current sensing assembly to close as long as the current sensing assembly does not detect a fault. Once the current sensing assembly detects a fault, the signal to the relay ceases and the relay open the circuit.

Additionally, in the foregoing embodiment, the output circuit is controlled by a relay and a contactor working in combination. In certain applications it may be desirable to incorporate the control functionality into a single automatic switching component that is controlled based on feedback from the current sensors and the noise detection assembly. Furthermore, although the circuit is described as having a single switching element (i.e.contactor 115) that controls the output of all of the source circuits simultaneously, it may be desirable to control each source circuit separately so that a particular source circuit can be interrupted without shutting down the entire system 20. Specifically, the current through each finger may be connected through a separate switching element, such as a contactor, which is controlled either directly or indirectly based on the current sensed for the current flowing through the particular finger. For instance, each finger may be connected to a separate relay, which in turn is connected to a separate contactor. If the control assembly detects a fault based on the detected current for the finger, the control assembly controls the relay associated with the finger, which in turn opens the power supply to the contactor for the finger, thereby opening the circuit from the finger. However, since each finger has a separate contactor and relay, the flow of electricity from the remaining fingers is not interrupted when the circuit from one of the fingers is opened.

In the embodiment in which a common contactor is used to open the circuit from the combiner box to the grid, a fault detected in one of the source circuits shuts down the flow of electricity from the combiner box for all of the source circuits, including the source circuits that are operating properly. Therefore, when the power from the combiner box is interrupted, it is not normally apparent which source circuit triggered the shut down. However, it is desirable to determine which source circuit triggered the shut down so that the source circuit can be analyzed to determine the potential source of the problem. Unless the particular source circuit can be identified, the operator may need to analyze the equipment for all of the source circuits, which significantly increases the labor required to identify the problem.

As described previously, the circuit may include a data logger that logs data regarding the signal sensed for each sensor in the sensor assembly. The user may analyze the data recorded by the data logger for each sensor to determine which sensor caused the shut down. Additionally, the circuit may be configured so that the data logger logs data received from the current sensing assembly identifying which sensor triggered the shut down.

As described above, the system is controlled by a controller that automatically shuts off the flow of electricity from the combiner box to the grid in response to detection of a current indicative of a problem in one of the source circuits (i.e. indicative of a fault) and the detection of noise indicative of a problem in one of the source circuits. In the foregoing description, the control assembly 50 is described as incorporating the control functions for controlling the relay 110. However, it should be understood that a control circuit separate from the current monitoring assembly may be provided for controlling the relay. The separate control would be in communication with the current monitoring assembly to receive either signals corresponding to the sensed current for each finger or signal indicative of a fault in the detected current from one of the sensors. Additionally, the separate control would be in communication with the noise detection assembly to receive either a signal corresponding to the sensed current from the noise detection assembly or a signal indicative of a fault detected by the noise detection assembly. The separate control circuit would then control the relay 110 in response to the signal(s) received from the current sensing assembly and the noise detection assembly.

In addition to an automatically controllable switching element, it may be desirable to incorporate a manually controllable switch for shutting down the output from the combiner box 120. For example, the system 110 may include a manually actuable switch 105 in series with the relay 110 and the power supply 120. The switch 105 is closed during normal operating procedures. However if the operator desires to disconnect the output from the combiner box, the operator can manually operate the switch to move the switch to the open position. In the open position, the switch opens the circuit from the power supply 120 to the contactor, so that the contactor changes to an open condition, opening the circuit from the combiner box to the grid.

It will be recognized by those skilled in the art that changes or modifications may be made to the above-described embodiments without departing from the broad inventive concepts of the invention. It should therefore be understood that this invention is not limited to the particular embodiments described herein, but is intended to include all changes and modifications that are within the scope of the invention as set forth in the claims.

## Claims

1. A system (10) for combining direct current power produced by a plurality of photovoltaic elements (PV1-PV4), comprising:
an enclosure (20);
a first terminal assembly (24) for receiving a conductor of a first polarity from each of the photovoltaic elements, wherein the first terminal assembly is disposed within the enclosure;
a second terminal (30) assembly for receiving a conductor of a second polarity from each of the photovoltaic elements, wherein the second polarity is opposite the first polarity, and the second terminal assembly is disposed within the enclosure, and wherein the second terminal assembly comprises:
a busbar (40) in electrical communication with each of the conductors of a second polarity from the photovoltaic elements so that the direct current from the photovoltaic elements is combined to form a single current at the busbar, wherein the busbar comprises:
a central conductive body (42);
a plurality of elongated fingers (44) projecting outwardly from the central conductive body;
a plurality of over-current protection elements (31) each connected to one of the conductors of a second polarity from one of the photovoltaic elements and one of the fingers of the busbar, wherein the over-current protection elements are operable to break the circuit between the busbar and the respective power producing photovoltaic element in the event the current from photovoltaic element exceeds a threshold, and wherein the fingers of the busbar are elongated to space the central conductive body of the busbar away from the over-current protection elements when the busbar fingers are connected with the over-current protection elements; and
a sensor (64) operable to detect variations in the current flowing through one of the busbar fingers;
a detector (162) for detecting noise indicative of a malfunction in one of the photovoltaic elements;
a controller (50) connected with the sensor and the detector, wherein the controller is operable to declare a malfunction in response to a signal from the sensor indicative of a malfunction and a signal from the detector indicative of a malfunction.

2. The system of claim 1 comprising an inverter (90) for receiving the combined power from the first terminal assembly and the second terminal assembly and converting the current from direct current to alternating current.

3. The system of any of claims 1-2 wherein in response to declaring a malfunction, the controller is operable to control an element (115) to disconnect the second terminal assembly from an output to disconnect the output from the photovoltaic elements.

4. The system of claim 1 including an automatically controllable switching element (115) for controlling the flow of electricity from the busbar wherein the switching element is a normally open contactor.

5. The system of claim 4 wherein the sensor comprises a Hall effect sensor.

6. The system of claim 5 comprising a plurality of said sensors, wherein the plurality of elongated fingers (44) are spaced apart from one another wherein each elongated finger is connected with a different one of a plurality of source circuits for delivering power from the photovoltaic elements and a separate sensor is mounted adjacent each elongated finger.

7. The system of any of claims 4-6 wherein the detector for detecting noise comprises a current transformer.

8. The system of claim 7 wherein the current transformer circumscribes a conductor electrically connected with the busbar.

9. The system of any of claims 4-8 wherein the switching element comprises a relay or a contactor.

10. The system of claim 9 wherein the switching element comprises a relay and a contactor.

11. A method employing the system recited in claim 1 for combining direct current power produced by a plurality of photovoltaic elements (PV1-4), comprising:
connecting a plurality of source circuits to a common conductor (40),
wherein the source circuits each provide an electrical current;
sensing the current from each source circuit;
sensing noise in the current in the common conductor;
automatically controlling a switching element (115) in response to the step of sensing the current sensed and the step of sensing noise, wherein the step of automatically controlling the switching element is operable to control the switching element to open the switch to interrupt the flow of electricity from the common conductor in response to the step of sensing noise indicative of a fault in one of the source circuits delivering power from one or more photovoltaic elements and the step of sensing current from each source circuit detecting a current indicative of a fault in one of the source circuits.

12. The method of claim 11 wherein the step of sensing noise comprises sensing noise in the current flowing through a current transformer (162).

13. The method of any of claims 11-12 comprising the step of connecting the current transformer so that the current transformer circumscribes a conductor electrically connected with the common conductor.

14. The method of any of claims 11-13 wherein the switching element comprises a relay or a contactor and the method comprises automatically controlling the relay or the contactor.

15. The method of any of claims 11-13 wherein the switching element comprises a relay and a contactor and the method comprises automatically controlling both the relay and the contactor.

## Patentansprüche

1. System (10) zum Kombinieren einer Gleichstromleistung, die von einer Vielzahl von Photovoltaikelementen (PV1 - PV4) produziert wird, umfassend:
ein Gehäuse (20);
eine erste Klemmenbaugruppe (24) zum Empfangen eines elektrischen Leiters einer ersten Polarität von jedem Photovoltaikelement, wobei die erste Klemmenbaugruppe in dem Gehäuse angeordnet ist;
eine zweite Klemmenbaugruppe (30) zum Empfangen eines elektrischen Leiters einer zweiten Polarität von jedem Photovoltaikelement, wobei die zweite Polarität entgegengesetzt zur ersten Polarität ist und wobei die zweite Klemmenbaugruppe in dem Gehäuse angeordnet ist und wobei die zweite Klemmenbaugruppe umfasst:
eine Sammelschiene (40) in einer elektrischen Verbindung mit jedem der elektrischen Leiter einer zweiten Polarität von den Photovoltaikelementen, sodass der Gleichstrom von den Photovoltaikelementen kombiniert wird, um einen einzigen Strom auf der Sammelschiene zu bilden, wobei die Sammelschiene umfasst:
einen zentralen leitfähigen Körper (42);
eine Vielzahl von länglichen Fingern (44), die sich von dem zentralen leitfähigen Körper nach außen erstrecken;
eine Vielzahl von Überstromschutzelementen (31), wobei jedes mit einem der elektrischen Leiter einer zweiten Polarität von einem der Photovoltaikelemente und einem der Finger der Sammelschiene verbunden ist, wobei die Überstromschutzelemente geeignet sind, den Schaltkreis zwischen der Sammelschiene und dem entsprechenden stromproduzierenden Photovoltaikelement in dem Fall zu unterbrechen, wenn der Strom von dem Photovoltaikelement einen Schwellenwert überschreitet, und wobei die Finger der Sammelschiene länglich sind, um den zentralen leitfähigen Körper der Sammelschiene von den Überstromschutzelementen zu entfernen, wenn die Sammelschienenfinger mit den Überstromschutzelementen verbunden sind; und
einen Sensor (64), der geeignet ist, um Variationen in dem Strom zu erkennen, der durch einen der Sammelschienenfinger fließt;
eine Erkennungseinheit (162) zum Erkennen eines Rauschens, das eine Fehlfunktion eines der Photovoltaikelemente anzeigt;
eine Steuereinheit (50), die mit dem Sensor und der Erkennungseinheit verbunden ist, wobei die Steuereinheit geeignet ist, um als Reaktion auf ein Signal von dem Sensor, das eine Fehlfunktion anzeigt, und auf ein Signal von der Erkennungseinheit, das eine Fehlfunktion anzeigt, eine Fehlfunktion festzustellen.

2. System nach Anspruch 1, das einen Wechselrichter (90) umfasst, um die kombinierte Leistung von der ersten Klemmenbaugruppe und der zweiten Klemmenbaugruppe zu empfangen und um den Strom von einem Gleichstrom in einen Wechselstrom zu wandeln.

3. System nach einem der Ansprüche 1 bis 2, wobei die Steuereinheit als Reaktion auf das Feststellen einer Fehlfunktion geeignet ist zum Steuern eines Elements (115), um die zweite Klemmenbaugruppe von einem Ausgang zu trennen, sodass der Ausgang von den Photovoltaikelementen getrennt wird.

4. System nach Anspruch 1, das ein automatisch steuerbares Schaltelement (115) umfasst, um den Fluss einer Elektrizität von der Sammelschiene zu steuern, wobei das Schaltelement ein normalerweise offener Schütz ist.

5. System nach Anspruch 4, wobei der Sensor einen Hall-Effekt-Sensor umfasst.

6. System nach Anspruch 5, das eine Vielzahl der Sensoren umfasst, wobei die Vielzahl von länglichen Fingern (44) in einem Abstand voneinander angeordnet sind, wobei jeder längliche Finger mit einem anderen aus einer Vielzahl von Quellenschaltkreisen verbunden ist, um Leistung von den Photovoltaikelement zuzuführen, und wobei in der Nähe jedes länglichen Fingers ein separater Sensor montiert ist.

7. System nach einem der Ansprüche 4 bis 6, wobei die Erkennungseinheit zum Erkennen eines Rauschens einen Stromwandler umfasst.

8. System nach Anspruch 7, wobei der Stromwandler einen elektrischen Leiter einschließt, der mit der Sammelschiene elektrisch verbunden ist.

9. System nach einem der Ansprüche 4 bis 8, wobei das Schaltelement ein Relais oder einen Schütz umfasst.

10. System nach Anspruch 9, wobei das Schaltelement ein Relais und einen Schütz umfasst.

11. Verfahren zum Einsetzen des Systems nach Anspruch 1 zum Kombinieren einer Gleichstromleistung, die von einer Vielzahl von Photovoltaikelementen (PV1 - PV4) produziert wird, wobei das Verfahren umfasst:
Verbinden einer Vielzahl von Quellenschaltkreisen mit einem gemeinsamen elektrischen Leiter (40), wobei jeder der Quellenschaltkreise einen elektrischen Strom bereitstellt;
Erfassen des Stroms von jedem Quellenschaltkreis;
Erfassen eines Rauschens in dem Strom des gemeinsamen elektrischen Leiters;
automatisches Steuern eines Schaltelements (115) als Reaktion auf den Schritt des Erfassens des erfassten Stroms und auf den Schritt des Erfassens eines Rauschens, wobei der Schritt des automatischen Steuerns des Schaltelements geeignet ist, um das Schaltelement so zu steuern, dass der Schalter geöffnet wird, um den Fluss einer Elektrizität von dem gemeinsamen elektrischen Leiter als Reaktion darauf zu unterbrechen, dass der Schritt des Erfassens eines Rauschens einen Fehler in einem der Quellenschaltkreise anzeigt, die eine Leistung von einem oder mehreren Photovoltaikelementen zuführen, und dass der Schritt des Erfassens des Stroms von jedem Quellenschaltkreis einen Strom erfasst, der einen Fehler in einem der Quellenschaltkreise anzeigt.

12. Verfahren nach Anspruch 11, wobei der Schritt des Erfassens eines Rauschens ein Erfassen eines Rauschens in dem Strom umfasst, der durch den Stromwandler (162) fließt.

13. Verfahren nach einem der Ansprüche 11 bis 12, das den Schritt eines Verbindens des Stromwandlers umfasst, sodass der Stromwandler einen elektrischen Leiter einschließt, der mit dem gemeinsamen elektrischen Leiter elektrisch verbunden ist.

14. Verfahren nach einem der Ansprüche 11 bis 13, wobei das Schaltelement ein Relais oder einen Schütz umfasst und wobei das Verfahren ein automatisches Steuern des Relais oder des Schützes umfasst.

15. Verfahren nach einem der Ansprüche 11 bis 13, wobei das Schaltelement ein Relais und einen Schütz umfasst und wobei das Verfahren ein automatisches Steuern sowohl des Relais als auch des Schützes umfasst.

## Revendications

1. Système (10) servant à combiner la puissance en courant continu produite par une pluralité d'éléments photovoltaïques (PV1-PV4), comprenant :
un boîtier (20) ;
un premier ensemble de bornes (24) destiné à recevoir un conducteur d'une première polarité provenant de chacun des éléments photovoltaïques, le premier ensemble de bornes étant disposé à l'intérieur du boîtier ;
un deuxième ensemble de bornes (30) destiné à recevoir un conducteur d'une deuxième polarité provenant de chacun des éléments photovoltaïques, la deuxième polarité étant opposée à la première polarité, le deuxième ensemble de bornes étant disposé à l'intérieur du boîtier, et le deuxième ensemble de bornes comprenant :
une barre omnibus (40) en communication électrique avec chacun des conducteurs d'une deuxième polarité provenant des éléments photovoltaïques de telle sorte que le courant continu provenant des éléments photovoltaïques est combiné pour former un seul courant au niveau de la barre omnibus, la barre omnibus comprenant :
un corps central conducteur (42) ;
une pluralité de doigts allongés (44) faisant saillie vers l'extérieur depuis le corps central conducteur ;
une pluralité d'éléments de protection contre les surintensités (31), chacun relié à un des conducteurs d'une deuxième polarité provenant d'un des éléments photovoltaïques et un des doigts de la barre omnibus, les éléments de protection contre les surintensités étant utilisables pour couper le circuit entre la barre omnibus et l'élément photovoltaïque produisant de l'électricité respectif dans le cas où le courant provenant de l'élément photovoltaïque dépasse un seuil, et les doigts de la barre omnibus étant allongés pour éloigner le corps central conducteur de la barre omnibus des éléments de protection contre les surintensités quand les doigts de la barre omnibus sont reliés aux éléments de protection contre les surintensités ; et
un capteur (64) utilisable pour détecter des variations dans le courant circulant à travers un des doigts de la barre omnibus ;
un détecteur (162) servant à détecter le bruit indicateur d'un dysfonctionnement dans un des éléments photovoltaïques ;
un contrôleur (50) relié au capteur et au détecteur, le contrôleur étant utilisable pour déclarer un dysfonctionnement en réponse à un signal provenant du capteur indicateur d'un dysfonctionnement et un signal provenant du détecteur indicateur d'un dysfonctionnement.

2. Système de la revendication 1 comprenant un onduleur (90) destiné à recevoir la puissance combinée provenant du premier ensemble de bornes et du deuxième ensemble de bornes et faire passer le courant d'un courant continu à un courant alternatif.

3. Système de l'une quelconque des revendications 1 et 2 dans lequel, en réponse à la déclaration d'un dysfonctionnement, le contrôleur est utilisable pour demander à un élément (115) de déconnecter le deuxième ensemble de bornes d'une sortie pour déconnecter la sortie des éléments photovoltaïques.

4. Système de la revendication 1 comportant un élément de commutation automatiquement contrôlable (115) servant à contrôler le flux d'électricité provenant de la barre omnibus, l'élément de commutation étant un contacteur normalement ouvert.

5. Système de la revendication 4 dans lequel le capteur comprend un capteur à effet Hall.

6. Système de la revendication 5 comprenant une pluralité desdits capteurs, les doigts de la pluralité de doigts allongés (44) étant espacés les uns des autres, chaque doigt allongé étant relié à un circuit différent d'une pluralité de circuits sources servant à délivrer la puissance provenant des éléments photovoltaïques, et un capteur distinct étant monté au voisinage de chaque doigt allongé.

7. Système de l'une quelconque de revendications 4 à 6 dans lequel le détecteur servant à détecter le bruit comprend un transformateur de courant.

8. Système de la revendication 7 dans lequel le transformateur de courant circonscrit un conducteur relié électriquement à la barre omnibus.

9. Système de l'une quelconque de revendications 4 à 8 dans lequel l'élément de commutation comprend un relais ou un contacteur.

10. Système de la revendication 9 dans lequel l'élément de commutation comprend un relais et un contacteur.

11. Procédé employant le système défini dans la revendication 1 pour combiner la puissance en courant continu produite par une pluralité d'éléments photovoltaïques (PV1-4), comprenant les étapes suivantes :
relier une pluralité de circuits sources à un conducteur commun (40), les circuits sources fournissant chacun un courant électrique ;
détecter le courant provenant de chaque circuit source ;
détecter le bruit dans le courant dans le conducteur commun ;
contrôler automatiquement un élément de commutation (115) en réponse à l'étape de détection du courant détecté et l'étape de détection du bruit, l'étape de contrôle automatique de l'élément de commutation étant utilisable pour demander à l'élément de commutation d'ouvrir le commutateur pour interrompre le flux d'électricité provenant du conducteur commun en réponse à l'étape de détection du bruit indicateur d'un défaut dans un des circuits sources délivrant la puissance provenant d'un ou plusieurs éléments photovoltaïques et l'étape de détection du courant provenant de chaque circuit source détectant un courant indicateur d'un défaut dans un des circuits sources.

12. Procédé de la revendication 11 dans lequel l'étape de détection du bruit comprend la détection du bruit dans le courant circulant à travers un transformateur de courant (162).

13. Procédé de l'une quelconque des revendications 11 et 12 comprenant l'étape consistant à brancher le transformateur de courant de telle sorte que le transformateur de courant circonscrive un conducteur relié électriquement au conducteur commun.

14. Procédé de l'une quelconque des revendications 11 à 13, l'élément de commutation comprenant un relais ou un contacteur et le procédé comprenant le contrôle automatique du relais ou du contacteur.

15. Procédé de l'une quelconque des revendications 11 à 13, l'élément de commutation comprenant un relais et un contacteur et le procédé comprenant le contrôle automatique du relais et du contacteur.
